(19) Europäisches Patentamt
European Patent Office
Office européen des brevets

(11) **EP 2 180 080 B1**

(12) **EUROPEAN PATENT SPECIFICATION**

(45) Date of publication and mention
of the grant of the patent:
**23.05.2012  Bulletin 2012/21**

(51) Int Cl.:
***C23C 14/24*** *(2006.01)*     ***C23C 14/56*** *(2006.01)*

(21) Application number: **08167326.1**

(22) Date of filing: **22.10.2008**

(54) **Evaporator device**

Verdampfervorrichtung

Dispositif évaporateur

(84) Designated Contracting States:
**AT BE BG CH CY CZ DE DK EE ES FI FR GB GR HR HU IE IS IT LI LT LU LV MC MT NL NO PL PT RO SE SI SK TR**

(43) Date of publication of application:
**28.04.2010  Bulletin 2010/17**

(73) Proprietor: **Applied Materials, Inc.**
**Santa Clara, CA 95054 (US)**

(72) Inventors:
• **Aulbach, Holger**
**63801 Kleinostheim (DE)**
• **Englert, Ulrich**
**63869 Heigenbrücken (DE)**

(74) Representative: **Zimmermann & Partner**
**Postfach 330 920**
**80069 München (DE)**

(56) References cited:
**EP-A- 0 336 618     JP-A- 9 228 032**

## Description

FIELD OF THE INVENTION

Embodiments of the invention generally relate to an evaporator device, particularly for evaporating materials, such as metals. More particularly, embodiments of the invention relate to an evaporator device, a method of mounting an evaporator device, a method of operating an evaporator device, and a coating device.

BACKGROUND OF THE INVENTION

Evaporator devices have many functions in a plurality of industrial fields, including, but not limited to, thin-film deposition applications in the production of displays, solar wafer manufacturing or in semiconductor device production. A typical evaporation deposition application is PVD (Physical Vapor Deposition).

In a typical PVD application, an evaporation crucible, which is provided with a material to be evaporated, is heated, for instance in a vacuum atmosphere, to the evaporating temperature of the material. Thereby, particles of the material are vaporized and travel towards a substrate to be coated.

Typical evaporator devices may include a housing encompassing an evaporator, on which the evaporation crucible may be supported and heated. The housing typically has an evaporation aperture for releasing the vapor produced inside of the housing towards the substrate to be coated. At the inner walls of the housing a shielding may be mounted, e.g. by screws. The shielding screens the inner walls of the housing from vapor particles and, in addition, from the heat emitted from the crucible. However, during evaporation, the shielding may also be heated, and therefore may deteriorate. Hence, in some cases, the shielding mounted at the inner walls of the housing is cooled. However, such cooling of the shielding may not be effective. Furthermore, during evaporation, the shielding is also coated with the vapor particles. Hence, from time to time, the coated shielding has to be replaced by an uncoated shielding, which may be a time consuming procedure requiring expensive materials.

JP 9228032 A discloses a vacuum deposition device preventing the intrusion of impurities into a thin film and furthermore capable of increasing the vacuum deposition efficiency and a vacuum deposition method provided by the same vacuum deposition device. A shielding part is provided, which is composed of an outside cylindrical body, an inside cylindrical body and an insulating cylindrical body, and vacuum deposition is executed in such a manner that the outside cylindrical body is held to -269 °C to room temperature and the inside cylindrical body is held to 70 to 600 °C.

EP 0336618 A is directed to a quick change sputter target assembly. A sputter source of the type which relies on thermal expansion of an annular sputter target to make good physical contact with a peripheral cooling wall is disclosed. Means are provided for holding the sputter target in place in the source when the source and target are at ambient temperature.

SUMMARY

In light of the above, an evaporator device according to independent claim 1, a method of mounting an evaporator device according to independent claim 12, a use of an evaporator device according to independent claim 13, and a coating device according to independent claim 15 are provided.

According to one embodiment, an evaporator device is provided, including a frame having an opening and being connectable to a cooling unit for cooling the frame, an evaporator being adapted for supporting an evaporator crucible within the frame, and a shielding frame, wherein the shielding frame is substantially concentrically within and adjacent to the frame detachably installable through the opening of the frame and wherein the shielding frame has a structure adapted for providing, when installed within the frame, a clearance to the frame at a non-operating temperature of the evaporator device and a close fit with the frame at an operating temperature of the evaporator device.

According to another embodiment, a method of mounting an evaporator device according to above one embodiment is provided, including providing an evaporator device having a frame having an opening and being connectable to a cooling unit for cooling the frame, an evaporator being adapted for supporting an evaporator crucible within the frame, and a shielding frame, wherein the shielding frame is substantially concentrically within and adjacent to the frame detachably installable through the opening of the frame, arranging the shielding frame substantially concentrically within and adjacent to the frame, and optionally installing an evaporator crucible at the evaporator.

According to a further embodiment, a use of an evaporator device according to above one embodiment is provided, including providing the evaporator device having a frame having an opening and being connectable to a cooling unit for cooling the frame, an evaporator being adapted for supporting an evaporator crucible within the frame, and a shielding frame, wherein the shielding frame is substantially concentrically within and adjacent to the frame detachably installable through the opening of the frame, the evaporator device having the shielding frame installed substantially concentrically within and adjacent to the frame, and having an evaporator crucible provided at the evaporator, cooling the frame, and heating the evaporator crucible.

According to a yet further embodiment, a coating device is provided, including an evaporator device according to above one embodiment. having a frame having an opening and being connectable to a cooling unit for cooling the frame, an evaporator being adapted for supporting an evaporator crucible within the frame, and a shielding frame, wherein the shielding frame is substantially concentrically within and adjacent to the frame detachably installable through the opening of the frame, the evaporator device having the shielding frame installed substantially concentrically within and adjacent to the frame, and having an evaporator crucible provided at the evaporator.

Further features and details are evident from the dependent claims, the description and the drawings.

Embodiments are also directed to apparatuses for carrying out the disclosed methods and including apparatus parts for performing described method steps. Furthermore, embodiments are also directed to methods by which the described apparatus operates or by which the described apparatus is manufactured. It may include method steps for carrying out functions of the apparatus or manufacturing parts of the apparatus. The method steps may be performed by way of hardware components, firmware, software, a computer programmed by appropriate software, by any combination thereof or in any other manner.

It is contemplated that elements of one embodiment may be advantageously utilized in other embodiments without further recitation.

BRIEF DESCRIPTION OF THE DRAWINGS

So that the manner in which the above recited features of the present invention can be understood in detail, a more particular description of embodiments of the invention, briefly summarized above, may be had by reference to embodiments. The accompanying drawings relate to embodiments of the invention and are described in the following. Some of the above mentioned embodiments will be described in more detail in the following description of typical embodiments with reference to the following drawings in which:

Figs. 1a to 1c show cross sectional views of an evaporator device according to one example of embodiments disclosed herein;

Figs. 2a to 2c show cross sectional views of an evaporator device according to another example of embodiments disclosed herein;

Fig. 3 shows a cross sectional view of an evaporator device according to a further example of embodiments disclosed herein;

Fig. 4 shows a cross sectional view of an evaporator device according to a yet further example of embodiments disclosed herein;

Fig. 5 shows a cross sectional view of an evaporator device according to an example of embodiments disclosed herein, illustrating how a material to be evaporated may be provided;

Fig. 6 shows a cross sectional view of an evaporator device according to a further example of embodiments disclosed herein, illustrating how a material to be evaporated may be provided.

DETAILED DESCRIPTION OF THE DRAWINGS

Reference will now be made in detail to the various embodiments, one ore more examples of which are illustrated in the figures. Each example is provided by way of explanation, and is not meant as a limitation of the invention.

Without limiting the scope, in the following, an evaporator device and corresponding methods of mounting and of operating an evaporator device according to embodiments disclosed herein are described, referring to an Aluminum evaporator. However, other materials, e.g. metals, metal alloys or plastic materials may be evaporated using the evaporator device of embodiments described herein. In particular, materials which may be provided to the evaporator as a wire may be vaporized with the evaporator device of embodiments described herein. Moreover, without limiting the scope of the present application, the following description refers to embodiments of an evaporator device which may be used in vacuum atmosphere.

Within the following description of the drawings, the same reference numbers refer to the same components. Generally, only the differences with respect to the individual embodiments are described. Further, in the following, the frame of the evaporator device may also be referred to as cooling frame. Moreover, the evaporator crucible may be referred to herein as crucible or evaporation crucible.

Typical applications of embodiments described herein are for example evaporation deposition applications in the production of displays, such as LCD, TFT, and OLED (Organic Light Emitting Diode) displays, solar wafer manufacturing and in semiconductor device production. Furthermore, typical substrates, which may be coated using the evaporator device according to embodiments disclosed herein, may be rigid or flexible, e.g. rigid glass substrates or flexible films, such as webs.

According to one embodiment, an evaporator device is provided, including: a frame having an opening and being connectable to a cooling unit for cooling the frame, an evaporator being adapted for supporting an evaporation crucible within the frame, and a shielding frame, wherein the shielding frame is substantially concentrically within and adjacent to the frame detachably installable through the opening of the frame. The shielding frame has a structure adapted for providing, when installed within the frame, a clearance to the frame at a non-operating temperature of the evaporator device and a close fit with the frame at an operating temperature of the evaporator device

According to embodiments disclosed herein, the shielding frame and the frame have the same three-dimensional form and the shielding frame has a smaller volume than the frame. For instance, the outer dimensions of the shielding frame may be smaller than the inner dimensions of the frame, such that at non-operating temperatures of the evaporator device, e.g. at ambient temperature, a clearance between the frame and the shielding frame is provided. In some embodiments, the shielding frame and the frame may be tubes, e.g. rectangular tubes or circular tubes.

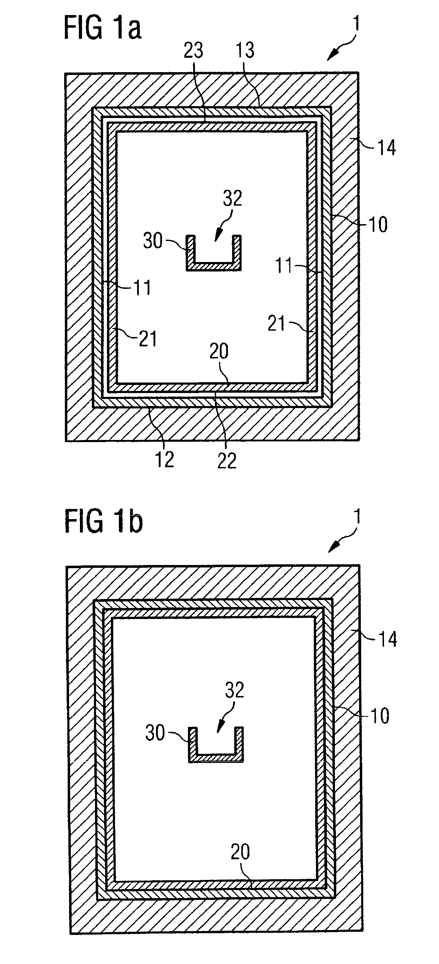

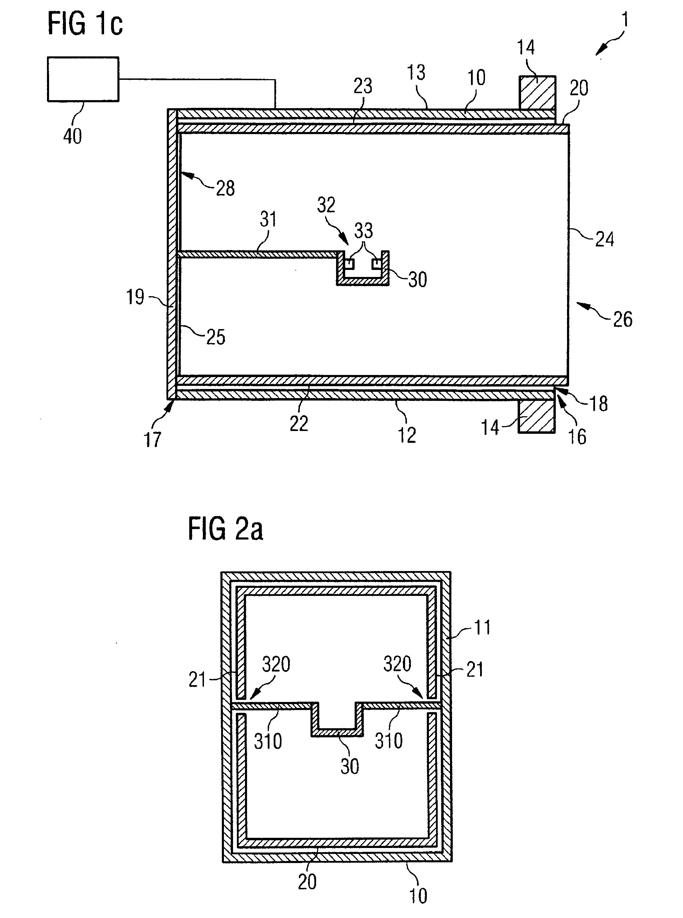

Figs. 1a to 1c illustrate cross sectional views of an evaporator device 1 according to one example of embodiments disclosed herein. Fig. 1c shows a cross sectional view along a longitudinal direction of the evaporator device 1. Figs. 1a and 1b are cross sectional views perpendicular to the longitudinal direction of the evaporator device 1.

Typically, the evaporator device 1 includes a cooling frame 10, a shielding frame 20 and an evaporator 30. In one example of embodiments disclosed herein, the cooling frame 10 and the shielding frame 20 may be rectangular tubes. Hence, in the example of Figs. 1a to 1c, the cooling frame 10 and the shielding frame 20 have rectangular cross sections.

In the example as shown in Fig. 1a, the cooling frame 10 has two side walls 11, a bottom wall 12 and a top wall 13. Further, the cooling frame 10 has a front side 16 and a back side 17, as illustrated in Fig. 1c. At the back side 17, the cooling frame may be closed by a lid 19, e.g. a back side shielding. Further, at the front side 16, the cooling frame 10 has an opening 18. The front side 16 of the cooling frame 10 is positioned at an evaporation side of the evaporator device.

In a typical example of embodiments, the cooling frame 10 is vacuum tight and may be mounted, e.g. welded, at its front side 16 to a vacuum flange 14, as illustrated in Fig. 1a to 1c. Vacuum flange 14 surrounds the front side 16 of the cooling frame 10. Hence, vacuum flange 14 may be mounted at a vacuum coating chamber of a coating device such that opening 18 of the cooling frame 10 and, hence, the evaporation side of the evaporator device is directed into the vacuum coating chamber.

According to one example of embodiments, as shown in Fig. 1c, at lid 19 of the cooling frame 10, an evaporator support 31 of the evaporator 30 may be mounted. The evaporator 30 includes a recess 32 positioned substantially in the centre of the cooling frame 10. In recess 31 an evaporator crucible (not shown), which may have a rough surface, may be mounted, e.g. by clamping. Recess 31 may for instance be a fixed bearing, in which a movable, electrically conductive bearing (not shown) for receiving, e.g. clamping, the crucible is provided. The evaporator 30 is connected to a heating current supply unit (not shown) and further includes electrical connectors 33, e.g. at the side walls of the recess 31 or of the bearings. Thereby, a heating current may be supplied to an evaporator crucible mounted in the recess 31. In alternative examples, the evaporator crucible may be heated by other means, such as a laser or an electron source.

Furthermore, the cooling frame 10 may be connected to a cooling unit 40, as shown in Fig. 1c. Hence, cooling frame 10 may be cooled by cooling unit 40.

According to embodiments disclosed herein, the evaporator device includes a shielding frame, which is detachably installable within the cooling frame through an opening thereof. Typically, the shielding frame is installable substantially concentrically within and adjacent to the cooling frame.

According to one embodiment, the opening of the frame is provided at the evaporation side of the evaporator device and the shielding frame has an opening and is installable within the frame such that the opening of the shielding frame is provided at the evaporation side of the evaporator device.

As an example of embodiments disclosed herein, Figs. 1a to 1c show the shielding frame 20 installed within cooling frame 10. Shielding frame 20 has two side walls 21, a bottom wall 22 and a top wall 23. Shielding frame 20 further includes a front side 24 and a back side 25. Front side 24 includes an opening 26, whereas back side 25 includes an opening 28. When evaporator device 1 is installed via vacuum flange 14 at a vacuum coating chamber, the opening 26 of the shielding frame 20 is directed into the vacuum coating chamber.

In embodiments disclosed herein, the shielding frame has a structure adapted for providing, when installed within the frame, a clearance to the frame at a non-operating temperature of the evaporator device and a close fit with the frame at an operating temperature of the evaporator device. Typically, the shielding frame may have a structure adapted for providing a clearance to the frame at a non-operating temperature of the evaporator crucible and a close fit with the frame at an operating temperature of the evaporator crucible. Alternatively or in addition, the shielding frame may have a structure adapted for providing a clearance to the frame at a non-operating temperature of the cooling unit and a close fit with the frame at an operating temperature of the cooling unit.

According to the example of embodiments shown in Figs. 1a to 1c, the shielding frame 20 has dimensions and a material such that a clearance is provided between the walls of the shielding frame 20 and the walls of the cooling frame 10, when the evaporator device 1 is not operated.

In examples of embodiments disclosed herein, the cooling frame 10, e.g. as shown in Fig. 1a, may have inner dimensions as follows: the inside height of the sidewalls 11 may be in the range of about 4 cm to about 125 cm; and the inside width of the bottom and top walls 12, 13 may be in the range of about 3 cm to about 114 cm. Further, the shielding frame 20 may have outer dimensions of the sidewalls 21 and of the bottom and top walls 22, 23, which are smaller, e.g. in a range about 0.1 mm to about 80 mm smaller, than the corresponding inner dimensions of cooling frame 10. The clearance, which is provided between the cooling frame 10 and the shielding frame 20 by choosing the respective inner and outer dimensions, depends on the thermal expansion properties of the materials of the cooling frame 10 and the shielding frame 20. The thickness of the walls of the cooling frame 10 and/or of the shielding frame 20 may be in a range of about 3 mm to about 100 mm, typically of about 6 mm. In one typical example, the cooling frame 10 and the shielding frame 20 may have square cross sections. A typical inside height and inside width of such a shielding frame 20 may for instance be about 20 cm x about 20 cm. The length, i.e. the dimension along the longitudinal axis of the evaporator device, of the cooling frame 10 and/or the shielding frame 20 may be in a range of about 50 cm to about 200 cm, typically about 125 cm.

The cooling frame 10 including the flange 14 may have a total outside length in a range of about 220 cm to about 50 cm, typically of about 125 cm. A typical outside width and/or outside height of the cooling frame 10 may be in a range of about 20 cm to about 50 cm, typically about 37 cm. In case of a cooling frame 10 having a square cross section, the outside cross sectional dimensions of the cooling frame may typically be about 37 cm x about 37 cm.

In some embodiments disclosed herein, the material of at least one of the shielding frame and the cooling frame may have a linear thermal expansion coefficient in the range of 5 x 10⁻⁶/K to 45 x 10⁻⁶/K at 20°C, typically in the range of 10 x 10⁻⁶/K to 20 x 10⁻⁶/K at 20°C. Alternatively or in addition, the material of at least one of the shielding frame and the cooling frame may have a volumetric thermal expansion coefficient in the range of 10 x 10⁻⁶/K to 90 x 10⁻⁶/K at 20°C, typically in the range of 30 x 10⁻⁶/K to 60 x 10⁻⁶/K at 20°C.

The linear thermal expansion of a material is the one-dimensional change with temperature and can be written:

$$\frac{\Delta L}{L_0} = \alpha_L \Delta T$$

wherein $\Delta L$ is the change in length after thermal expansion, $L_0$ is the original length, $\Delta T$ is the change of temperature, and $\alpha_L$ is the linear thermal expansion coefficient.

The change in volume with temperature, i.e. the volumetric thermal expansion of a material can be written:

$$\frac{\Delta V}{V_0} = \alpha_V \Delta T$$

wherein $\Delta V$ is the change in volume after thermal expansion, $V_0$ is the original volume, $\Delta T$ is the change of temperature, and $\alpha_V$ is the volumetric thermal expansion coefficient.

For instance, according to a typical example of embodiments, the shielding frame 20 and the cooling frame 10 consist of vacuum compatible stainless steel, which e.g. has a linear thermal expansion coefficient of 17.3 x 10⁻⁶/K at 20°C and a volumetric thermal expansion coefficient in the range of 51.9 x 10⁻⁶/K at 20°C. Moreover, the cooling frame 10, an example of which is shown in Fig. 1a, may have inner dimensions, i.e. an inside height of the sidewalls 11 and an inside width of the bottom and top walls 12, 13, of e.g. about 10 cm. Further, the shielding frame 20 may have outer dimensions of the sidewalls 21 and of the bottom and top walls 22, 23, which are e.g. about 2 mm smaller than the inner dimensions of the sidewalls and the bottom and top walls of cooling frame 10.

Therefore, at ambient temperature, there is a clearance between the shielding frame 20 and the cooling frame 10 of the evaporator device 1 when they are assembled. Hence, the shielding frame 20 can be installed within cooling frame 10 by arranging the shielding frame 20 in the opening 18 of the cooling frame 10 and pushing it along the longitudinal direction of the cooling frame 10 up to the lid 19. Typically, the opening 26 of the shielding frame 20 forms the evaporation opening of the evaporator device 1. When the evaporator device is operated, the cooling frame 10 is cooled, and an evaporator crucible (not shown) installed in recess 32 of the evaporator 30 is heated, e.g. to more than about 1300°C in a high vacuum atmosphere. Hence, the shielding frame 20 expands in correspondence with the linear and volumetric expansion coefficient of the material of the shielding frame 20. Moreover, the cooling frame 10 may shrink in correspondence with the linear or volumetric expansion coefficient of the material of the cooling frame 10. Thereby, at operating temperatures of the evaporator device 1, the shielding frame 20 has a close fit with the cooling frame 10, as shown in Fig. 1b, such that some or all of the walls of the shielding frame 20 are in close contact to the inner walls of the cooling frame 10. As a result, large areas of the shielding frame 20 are cooled. Hence, the cooling is more effective as compared to a shielding mounted via a few screws at a distance to the cooling frame. Moreover, the shielding frame 20 is fixed inside of the cooling frame 10 during operation of the evaporator device. In addition, at non-operating temperatures, e.g. at ambient temperature, an easy and quick installation or exchange of the shielding frame is possible. Moreover, inexpensive shielding materials may be used. Further, the structure of the evaporator device 1 is simple and allows mounting and dismounting of the shielding frame without using installation tools or screws.

In one example of embodiments disclosed herein, shielding frame 20 protrudes from the opening 18 of the cooling frame 10, as shown in Fig. 1c. Thereby, front faces at the evaporation side of the evaporator device 1, e.g. flange 14, may also be shielded by shielding frame 20.

According to examples of embodiments disclosed herein, the evaporator is mounted at an inner wall of the cooling frame. Furthermore, the shielding frame may have at least one recess for receiving the evaporator.

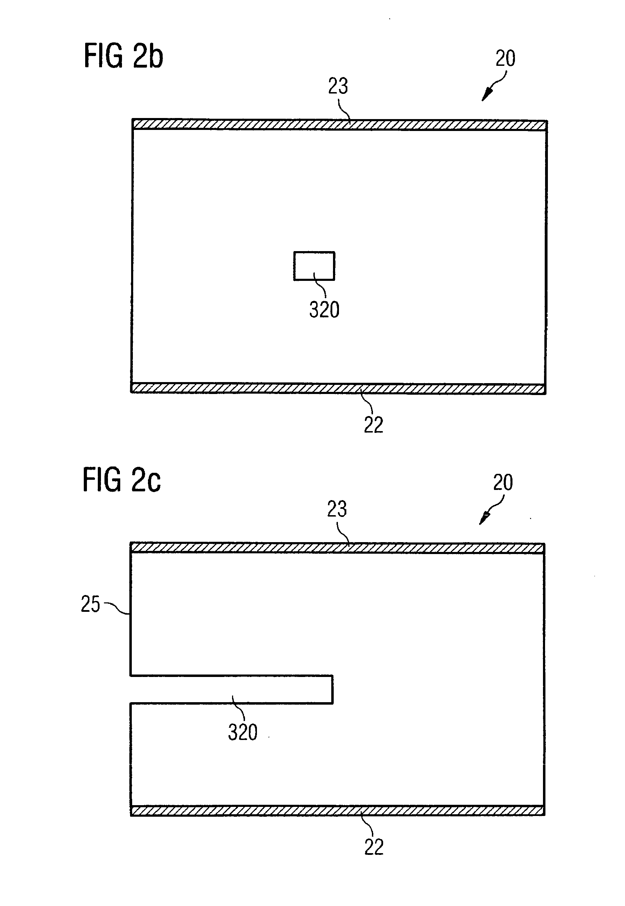

In one typical variation of the example shown in Figs. 1a to 1c, the evaporator 30 may include two evaporator supports 310 and extends from one side wall 11 to the other side wall 11 of the cooling frame 10. This variation is illustrated in Figs. 2a to 2c, in which flange 14 is not shown. That means, instead of evaporator support 31, which is mounted at the back side lid 19 of cooling frame 10, the evaporator supports 310 mounted at the two side walls 11 of the cooling frame 10, as shown in Fig. 2a, support the evaporator 30. Hence, the shielding frame 20 includes in each side wall 21 a recess 320. Recesses 320 encompass the lateral parts of the evaporator supports. In case that the evaporator supports 310 are detachably mounted at cooling frame 10, the recesses 320 may be circular or rectangular apertures. A corresponding example of the shielding frame 20 is shown in Fig. 2b. Further, in case that the evaporator supports 310 are fixed at cooling frame 10 or have to remain mounted thereon during exchange of the shielding frame 20, the recesses 320 may be longitudinal apertures extending to the back side 25 of the shielding frame 20. This variation of the shielding frame 20 is illustrated in Fig. 2c. Hence, shielding frame 20 including longitudinal recesses 320 as shown in Fig. 2c, may be pushed into cooling frame 10 through opening 18 up to the lid 19 without interfering with fixed evaporator supports 310.

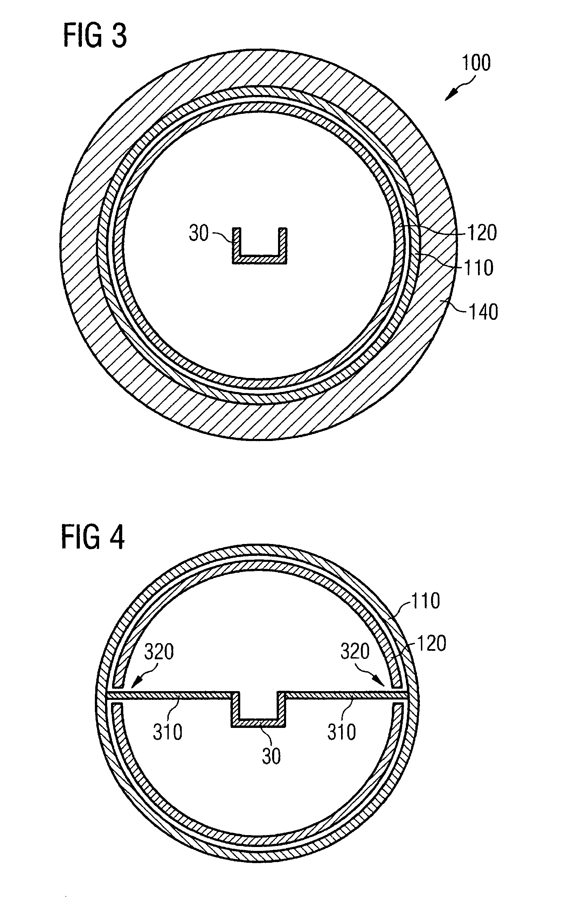

In some embodiments disclosed herein, the cooling frame 10 and the shielding frame 20 of the evaporator device may be circular tubes. For instance, Figs. 3 to 6 illustrate an evaporator device 100 which differs from the evaporator device 1 shown in Figs. 1a to 2c by the shapes of the cooling and the shielding frames.

Fig. 3 illustrates an example of the evaporator device 100, which differs from evaporator device 1 shown in Figs. 1a to 1c in that it has a cooling frame 110 and a shielding frame 120, which are circular tubes. Further, the cooling frame 110 is surrounded by a circular flange 140. The evaporator 30 is mounted at a circular back side lid of cooling frame 120.

The example of Fig. 4 corresponds to the example shown in Fig. 2a except for the three-dimensional form of the cooling and the shielding frames, which are circular tubes. The evaporator supports 310 of evaporator 30 are mounted at opposite positions of the inner wall of cooling frame 110. Hence, the shielding frame 120 has recesses for receiving the evaporator supports 310. The recesses may be, e.g. rectangular, openings or may be longitudinal apertures extending to the back side of shielding frame 20, corresponding to the recesses 320 shown in the examples of Figs. 2b and 2c.

Typical inner diameter of the cooling frame 110 may be in the range of about 50 mm to about 1250 mm, typically about 200 to about 700 mm. Moreover, the outer diameter of the shielding frame 120 may be smaller, e.g.

in a range of about 0.2 mm to about 160 mm smaller, than the corresponding inner dimensions of cooling frame 10, depending on the linear or volumetric expansion coefficient of the shielding material and/or the cooling frame material. The thickness of the walls of the cooling frame 110 and/or of the shielding frame 120 may be in a range of about 3 mm to about 100 mm, typically of about 6 mm. In one typical example, the shielding frame 200 may have an internal diameter of about 20 cm. The length, i.e. the dimension along the longitudinal axis of the evaporator device, of the cooling frame 100 and/or the shielding frame 200 may be in a range of about 50 cm to about 200 cm, typically about 125 cm.

The cooling frame 100 including the flange 140 may have a total outside length in a range of about 220 cm to about 50 cm, typically of about 125 cm. A typical external diameter of the cooling frame 100 may be in a range of about 20 cm to about 50 cm, typically about 37 cm.

For instance, according to a typical example of embodiments disclosed herein, the shielding frame 120 and the cooling frame 110 consist of vacuum compatible stainless steel, which e.g. has a linear thermal expansion coefficient of $17.3 \times 10^{-6}$/K at 20°C and a volumetric thermal expansion coefficient in the range of $51.9 \times 10^{-6}$/K at 20°C. Moreover, the cooling frame 110 may have an inner diameter of e.g. about 10 cm. Further, the shielding frame 20 may have an outer diameter which is e.g. about 4 mm smaller than the inner diameter of cooling frame 10.

Therefore, at ambient temperature, there is a clearance between the shielding frame 120 and the cooling frame 110 of the evaporator device 100 when they are assembled. Hence, the shielding frame 120 can be installed within cooling frame 110 by arranging the shielding frame 120 in the opening 18 of the cooling frame 110 and pushing it along the longitudinal direction of the cooling frame 110 up to the back side lid thereof. However, when the evaporator device is operated, the cooling frame 110 is cooled, and an evaporator crucible (not shown) installed in recess 32 of the evaporator 30 is heated, e.g. to about 1300°C. Hence, the shielding frame 120 expands in correspondence with the linear and volumetric expansion coefficient of the material of the shielding frame 120. Moreover, the cooling frame 110 may shrink in correspondence with the linear or volumetric expansion coefficient of the material of the cooling frame 110. Thereby, at operating temperatures of the evaporator device 100, the shielding frame 120 has a close fit with the cooling frame 110, such that the outer wall of the shielding frame 120 is in close contact to the inner wall of the cooling frame 110. As a result, a large area of the shielding frame 120 is cooled. Hence, the cooling is more effective as compared to a shielding mounted via a few screws at a distance to the cooling frame. Moreover, the shielding frame 120 is fixed inside of the cooling frame 110 during operation of the evaporator device. In addition, at non-operating temperatures, e.g. at ambient temperature, an easy and quick installation or exchange of the shielding frame is possible. Further, the structure of evaporator device 100 is simple and allows mounting and dismounting of the shielding without using installation tools or screws.

Typically, in a vacuum atmosphere, the evaporator device of embodiments disclosed herein produces a vapor cloud which may have a clubbed shape. When the evaporator device of embodiments disclosed herein is mounted via a vacuum flange, e.g. vacuum flange 14, at a vacuum coating chamber, the vapor cloud produced during evaporation may extend from the opening 26 of the shielding frame 20 into the coating chamber. For instance, at its maximum extension, the vapor cloud may have a diameter of up to about 1000 mm, typically of about 300 mm to about 800 mm, more typically of about 500 mm to about 600 mm.

A typical example of materials which may be evaporated using the evaporator devices 1 and 100 is Aluminum. However, other materials, such as other metals, e.g. Magnesium or Tin, metal alloys or plastics, may be contemplated. Typically, the material or materials to be evaporated may be provided in the form of a wire or wires, respectively.

According to one example of embodiments disclosed herein, the evaporator device includes a wire chamber adapted for continuously or discontinuously feeding a wire of material to be evaporated into the evaporator. Hence, according to another example of embodiments disclosed herein, during operation of the assembled evaporator device of embodiments disclosed herein, the wire may be continuously or discontinuously fed into the evaporator. Typically, the wire may be continuously fed into an evaporator crucible mounted in recess 32 of the evaporator 30. For instance, the wire may be introduced into the interior of the shielding frame 20 through the front side opening 26 of the shielding frame 20. As mentioned above, in some examples, the front side opening of the shielding frame is the evaporation opening of the evaporator device. That means, the wire may be introduced into the evaporator device through the evaporation opening. For example, a so called wire chamber may be mounted next to the evaporator device, e.g. at an extension of the flange 14 or 140. The wire chamber may be designed for encompassing a coil of the wire and continuously or discontinuously uncoiling the wire. Hence, the wire may be continuously or discontinuously transported into the crucible from the wire chamber which is mounted next to the evaporator device. Therefore, the feeding of the wire may be performed at the evaporation side of the evaporator device. In a variation of this example, e.g. in case that the shielding frame 20, 120 protrudes from the opening 18 of the cooling frame 10, 110, as shown in Fig. 1c, the protrusion of the shielding frame may have an aperture for feeding the wire into the evaporator.

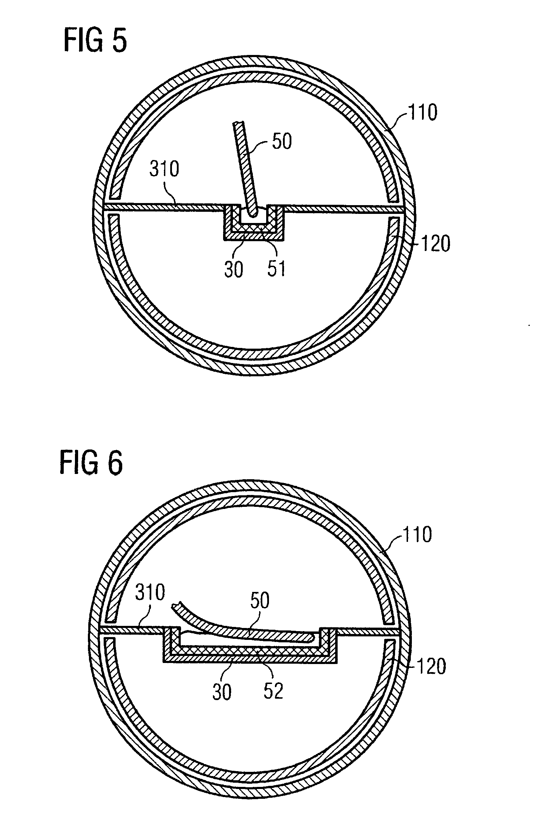

Figs. 5 and 6 show examples of embodiments, illustrating the feeding of the wire of a material to be evaporated, departing from the example shown in Fig. 4. In the example of Fig. 5, a wire 50 is introduced from above through the evaporation opening of the evaporator device 100 into a crucible 51. Therefore, the wire chamber (not shown) may be installed at the flange 140 above the cooling frame 110.

According to an alternative example, as illustrated in Fig. 6, an evaporator crucible 52, and the corresponding recess of the evaporator 30, may be longitudinally extended in the transverse direction of the evaporator device 100. In this case, the wire 50 may be fed sideways through the evaporation opening into the crucible 52. Hence, the wire chamber (not shown) may be laterally installed at flange 140. As illustrated in Fig. 6, using the present example, a larger amount of the wire is fed into the crucible 52 at a time. Therefore, the lateral feeding of the wire in this example may provide a larger evaporation rate as compared to the example shown in Fig. 5.

In a further example of embodiments disclosed herein, a method of mounting an evaporator device is provided, including providing an evaporator device according to any of the examples described above, arranging the shielding frame substantially concentrically within and adjacent to the frame, and optionally installing an evaporation crucible at the evaporator.

For instance, in a typical example of a method for mounting the evaporator device, described referring to the example shown in Fig. 4, the installation procedure may be as follows: the cooling frame 110 is connected to the cooling unit, and the shielding frame 120, and the evaporator 30 are provided. The shielding frame 120 has, in this example, two opposite lateral openings 320 for receiving the evaporator supports 310. Thereafter, the shielding frame 120 is arranged concentrically within cooling frame 110 at the front side opening thereof, such that the openings 320 are positioned laterally in the cooling frame 110. Then, the shielding frame 120 is pushed along the longitudinal direction of the cooling frame 110 up to the back side lid thereof. After that, in the present example, evaporator 30 is mounted at the cooling frame 110, the evaporator supports 310 extending through the openings 320 of the shielding frame. Then, an evaporator crucible is mounted, e.g. clamped, into recess 32 of the evaporator 30. This may in one example performed by clamping the crucible into a movable, electrically conductive bearing of the evaporator and arranging the movable bearing in recess 32, which is a fixed bearing. Thereby, the crucible is brought into contact with the electrical connectors 33 of the evaporator 30 and the evaporator device 100 is ready for use.

Further, according to embodiments disclosed herein, because of the clearance between the shielding frame and the cooling frame of the assembled evaporator device at non-operating temperatures, the shielding frame can be easily exchanged. This may for instance be done by releasing the crucible from the evaporator recess 32, thereby releasing the electrical connectors 33, dismounting the evaporator 30 and removing the shielding frame 20 or 120 from the cooling frame 10 or 110, respectively, through the opening 18 of the cooling frame.

The removed shielding frame may then be discarded, if the material of the shielding frame is inexpensive. Alternatively, e.g. if the material of the shielding frame is expensive, the exchanged shielding frame may be restored by a cleaning procedure and may be mounted again in the evaporator device. For instance, a shielding frame made of vacuum compatible stainless steel and used during evaporation of Aluminum can be cleaned by treating it with an alkaline solution, e.g. NaOH.

In other examples of embodiments disclosed herein, as mentioned e.g. with respect to Fig. 2a and 2c, the evaporator device may have an evaporator fixed at an inner wall of the cooling frame. The shielding frame may then have at least one longitudinal recess for receiving the evaporator support or evaporator supports, the recess extending to the back side of the shielding frame. Hence, the evaporator 30 may remain fixed during mounting and dismounting the shielding frame.

In one embodiment, a method of operating an evaporator device, is provided, including providing an evaporator device according to any of the examples described above, the evaporator device having the shielding frame installed substantially concentrically within and adjacent to the frame, having an evaporator crucible provided at the evaporator, and optionally having the frame connected to the cooling unit, cooling the frame, and heating the evaporator crucible.

Hence, in one example of a method of operating an evaporator device according to embodiments disclosed herein, after mounting the evaporator device 100 as described above e.g. in a coating chamber, a vacuum may be established in the coating chamber, if necessary. Then, the cooling unit is started and the cooling frame 110 is cooled. After that, the evaporator is heated and a desired evaporation is performed, e.g. while substrates to be coated are continuously transported in front of the evaporation opening of the evaporator device 100. Since the shielding frame expands during heating of the crucible, a close fit between the shielding frame 120 and the cooling frame 110 is provided. Therefore, large areas of the shielding frame 120 are cooled. Further, the shielding frame 120 is fixed inside of the coating frame 110 during evaporation.

After coating of the substrates using the evaporator device according to embodiments disclosed herein, the heating of the crucible may be stopped. Hence, the crucible and the shielding frame cool down. The shielding frame 120 shrinks and is loosened from the cooling frame 110. Hence, an exchange of the shielding frame 120 may easily be performed, if necessary.

In one embodiment, a coating device may include an evaporation device according to any of the examples of embodiments described. For instance, the coating device may be a vacuum coating installation. In some examples of a coating device according to embodiments, a plurality of evaporator devices may be installed in an array or in line at a coating device, e.g. if large-area substrates have to be coated.

When using an evaporator device and performing a method of operating an evaporator device according to embodiments disclosed herein, the cooling is more effective as compared to an evaporator device or an operating method using a shielding mounted via a few screws at a distance to the cooling frame of the evaporator device. Moreover, during operation of the evaporator device the shielding frame may be fixed inside of the cooling frame. In addition, at non-operating temperatures, e.g. at ambient temperature, an easy and quick installation or exchange of the shielding frame is possible. Moreover, inexpensive shielding materials may be used, reducing the costs. Further, the structure of the evaporator device is simple and allows mounting and dismounting of the shielding frame without using installation tools or screws.

According to one embodiment, an evaporator device is provided, including a frame having an opening and being connectable to a cooling unit for cooling the frame, an evaporator being adapted for supporting an evaporation crucible within the frame, and a shielding frame, wherein the shielding frame is substantially concentrically within and adjacent to the frame detachably installable through the opening of the frame.

The shielding frame has a structure adapted for providing, when installed within the frame, a clearance to the frame at a non-operating temperature of the evaporator device and a close fit with the frame at an operating temperature of the evaporator device.

In some embodiments described herein, the shielding frame has a structure adapted for providing a clearance to the frame at a non-operating temperature of the evaporator crucible and a close fit with the frame at an operating temperature of the evaporator crucible.

In some embodiments described herein, the evaporator device has an evaporation side, the opening of the frame is provided at the evaporation side of the evaporator device,

In some embodiments described herein, the shielding frame has an opening and is installable within the frame such that the opening of the shielding frame is provided at the evaporation side of the evaporator device.

In some embodiments described herein, the evaporator is provided at an inner wall of the frame.

In some embodiments described herein, the shielding frame has at least one recess for receiving the evaporator.

In some embodiments described herein, the evaporator includes an electrical connector adapted for supplying heating current to an evaporator crucible supported on the evaporator.

In some embodiments described herein, the shielding frame and the frame have the same three-dimensional form and the shielding frame has a smaller volume than the frame.

In some embodiments described herein, the shielding frame and the frame are hollow cylinders.

In some embodiments described herein, the shielding frame and the frame are each tubular and/or the openings of the frame and of the shielding frame are tube openings.

In some embodiments described herein, the shielding frame and the frame have materials and dimensions adapted for providing, when the shielding frame is installed within the frame, a clearance between the shielding frame and the frame at an non-operating temperature of the evaporator device, and a close fit between the shielding frame and the frame at an operating temperature of the evaporator device.

In some embodiments described herein, the material of at least one of the shielding frame and the frame has a linear thermal expansion coefficient in the range of $5 \times 10^{-6}$/K to $45 \times 10^{-6}$/K at 20°C, or in the range of $10 \times 10^{-6}$/K to $20 \times 10^{-6}$/K at 20°C,

In some embodiments described herein, the material of at least one of the shielding frame and the frame has a volumetric thermal expansion coefficient in the range of $10 \times 10^{-6}$/K to $90 \times 10^{-6}$/K at 20°C, or in the range of $30 \times 10^{-6}$/K to $60 \times 10^{-6}$/K at 20°C.

In some embodiments described herein, the material of at least one of the shielding frame and of the frame includes a metal.

In some embodiments described herein, the material of at least one of the shielding frame and the frame includes at least one element selected from the group consisting of a refractory metal, Iron and stainless steel.

According to another embodiment, a method of mounting an evaporator device is provided, including providing an evaporator device having a frame having an opening and being connectable to a cooling unit for cooling the frame, an evaporator being adapted for supporting an evaporation crucible within the frame, and a shielding frame, wherein the shielding frame is substantially concentrically within and adjacent to the frame detachably installable through the opening of the frame, arranging the shielding frame substantially concentrically within and adjacent to the frame, and optionally installing an evaporation crucible at the evaporator.

In some embodiments of a mounting method described herein, the shielding frame has a structure adapted for providing, when installed within the frame, a clearance to the frame at a non-operating temperature of the evaporator device and a close fit with the frame at an operating temperature of the evaporator device.

In some embodiments of a mounting method described herein, the shielding frame has a structure adapted for providing a clearance to the frame at a non-operating temperature of the evaporator crucible and a close fit with the frame at an operating temperature of the evaporator crucible.

According to a further embodiment, a method of operating an evaporator device is provided, including providing an evaporator device having a frame having an opening and being connectable to a cooling unit for cooling the frame, an evaporator being adapted for supporting an evaporator crucible within the frame, and a shielding frame, wherein the shielding frame is substantially concentrically within and adjacent to the frame detachably installable through the opening of the frame, the evaporator device having the shielding frame installed substantially concentrically within and adjacent to the frame, having an evaporator crucible provided at the evaporator, and optionally having the frame connected to the cooling unit, cooling the frame, and heating the evaporator crucible.

In some embodiments of an operating method described herein, the shielding frame has a structure adapted for providing, when installed within the frame, a clearance to the frame at a non-operating temperature of the evaporator device and a close fit with the frame at an operating temperature of the evaporator device.

In some embodiments of an operating method described herein, the shielding frame has a structure adapted for providing a clearance to the frame at a non-operating temperature of the evaporator crucible and a close fit with the frame at an operating temperature of the evaporator crucible.

According to a yet further embodiment, a coating device is provided, including an evaporator device having a frame having an opening and being connectable to a cooling unit for cooling the frame, an evaporator being adapted for supporting an evaporation crucible within the frame, and a shielding frame, wherein the shielding frame is substantially concentrically within and adjacent to the frame detachably installable through the opening of the frame, the evaporator device having the shielding frame installed substantially concentrically within and adjacent to the frame, having an evaporation crucible provided at the evaporator, and optionally having the frame connected to the cooling unit.

In some embodiments described herein, the coating device and/or the evaporator device are adapted for coating in vacuum.

In some embodiments of a coating device described herein, the shielding frame has a structure adapted for providing, when installed within the frame, a clearance to the frame at a non-operating temperature of the evaporator device and a close fit with the frame at an operating temperature of the evaporator device.

In some embodiments of a coating device described herein, the shielding frame has a structure adapted for providing a clearance to the frame at a non-operating temperature of the evaporator crucible and a close fit with the frame at an operating temperature of the evaporator crucible.

While the foregoing is directed to embodiments of the invention, other and further embodiments of the invention may be devised without departing from the basic scope thereof, and the scope thereof is determined by the claims that follow.

## Claims

1. An evaporator device comprising:

   a frame (10) having an opening and being connectable to a cooling unit for cooling the frame, an evaporator (30) being adapted for supporting an evaporator crucible within the frame, and a shielding frame (20),
   wherein
   the shielding frame is substantially concentrically within and adjacent to the frame detachably installable through the opening of the frame, and wherein the shielding frame has a structure adapted for providing, when installed within the frame, a clearance to the frame at a non-operating temperature of the evaporator device and a close fit with the frame at an operating temperature of the evaporator device.

2. The evaporator device of claims 1, wherein the shielding frame has a structure adapted for providing a clearance to the frame at a non-operating temperature of the evaporator crucible and a close fit with the frame at an operating temperature of the evaporator crucible.

3. The evaporator device of any of the preceding claims, wherein
   the evaporator device has an evaporation side, the opening of the frame is provided at the evaporation side of the evaporator device, and/or the shielding frame has an opening and is installable within the frame such that the opening of the shielding frame is provided at the evaporation side of the evaporator device.

4. The evaporator device of any of the preceding claims, wherein the evaporator is provided at an inner wall of the frame, and/or the shielding frame has at least one recess for receiving the evaporator.

5. The evaporator device of any of the preceding claims, wherein the evaporator comprises an electrical connector adapted for supplying heating current to an evaporator crucible supported on the evaporator.

6. The evaporator device of any of the preceding claims, wherein the shielding frame and the frame have the same three-dimensional form and the shielding frame has a smaller volume than the frame.

7. The evaporator device of any of the preceding claims, wherein the shielding frame and the frame are hollow cylinders.

8. The evaporator device of any of the preceding claims, wherein the shielding frame and the frame are each tubular and/or the openings of the frame and of the shielding frame are tube openings.

9. The evaporator device of any of the preceding claims, wherein the shielding frame and the frame have materials and dimensions adapted for providing, when the shielding frame is installed within the frame, a clearance between the shielding frame and the frame at an non-operating temperature of the evaporator device, and a close fit between the shielding frame and the frame at an operating temperature of the evaporator device.

10. The evaporator device of any of the preceding claims,
    wherein the material of at least one of the shielding frame and the frame has a linear thermal expansion coefficient in the range of $5 \times 10^{-6}/K$ to $45 \times 10^{-6}K$ at 20°C, or in the range of $10 \times 10^{-6}/K$ to $20 \times 10^{-6}/K$ at 20°C, and/or
    wherein the material of at least one of the shielding frame and the frame has a volumetric thermal expansion coefficient in the range of $10 \times 10^{-6}/K$ to $90 \times 10^{-6}/K$ at 20°C, or in the range of $30 \times 10^{-6}/K$ to $60 \times 10^{-6}/K$ at 20°C.

11. The evaporator device of any of the preceding claims, wherein the material of at least one of the shielding frame and of the frame includes a metal, and/or wherein the material of at least one of the shielding frame and the frame includes at least one element selected from the group consisting of a refractory metal, Iron and stainless steel.

12. A method of mounting an evaporator device, comprising
    providing an evaporator device according to any of claims 1 to 11, arranging the shielding frame substantially concentrically within and adjacent to the frame, and optionally installing an evaporator crucible at the evaporator.

13. Use of an evaporator device According o any of claims 1 to 11 in a method of operating an evaporator device, comprising
    providing the evaporator device having the shielding frame installed substantially concentrically within and adjacent to the frame, and having an evaporator crucible provided at the evaporator, cooling the frame, and heating the evaporator crucible.

14. The use of claim 13, wherein the evaporator device is used in a method of coating one or more substrates.

**15.** Coating device, comprising an evaporator device according to any of claims 1 to 11.

**Patentansprüche**

**1.** Verdampfervorrichtung, umfassend:

einen Rahmen (10), der eine Öffnung aufweist und mit einer Kühleinheit zum Kühlen des Rahmens verbindbar ist,
einen Verdampfer (30), der ausgelegt ist zum Halten eines Verdampfertiegels innerhalb von dem Rahmen, und
einen Abschirmrahmen (20),
wobei
der Abschirmrahmen im Wesentlichen konzentrisch innerhalb von dem und angrenzend an den Rahmen abnehmbar durch die Öffnung des Rahmens anbringbar ist, und
wobei der Abschirmrahmen einen Aufbau aufweist, der ausgelegt ist zum Bereitstellen, wenn er innerhalb des Rahmens angebracht ist, eines Freiraums zu dem Rahmen bei einer Nicht-Betriebstemperatur der Verdampfervorrichtung und einer engen Passung mit dem Rahmen bei einer Betriebstemperatur der Verdampfervorrichtung.

**2.** Verdampfervorrichtung nach Anspruch 1, wobei der Abschirmrahmen einen Aufbau aufweist, der ausgelegt ist zum Bereitstellen eines Freiraums zu dem Rahmen bei einer Nicht-Betriebstemperatur des Verdampfertiegels und einer engen Passung mit dem Rahmen bei einer Betriebstemperatur des Verdampfertiegels.

**3.** Verdampfervorrichtung nach einem der voranstehenden Ansprüche, wobei
die Verdampfervorrichtung eine Verdampfungsseite aufweist,
die Öffnung des Rahmens an der Verdampfungsseite der Verdampfervorrichtung bereitgestellt ist und/oder
der Abschirmrahmen eine Öffnung aufweist und innerhalb des Rahmens anbringbar ist, derart, dass die Öffnung des Abschirmrahmens an der Verdampfungsseite der Verdampfervorrichtung bereitgestellt ist.

**4.** Verdampfervorrichtung nach einem der voranstehenden Ansprüche, wobei der Verdampfer an einer Innenwand des Rahmens bereitgestellt ist und/oder der Abschirmrahmen zumindest eine Aussparung zum Aufnehmen des Verdampfers aufweist.

**5.** Verdampfervorrichtung nach einem der voranstehenden Ansprüche, wobei der Verdampfer einen elektrischen Verbinder umfasst, der ausgelegt ist zum Zuführen von Heizstrom zu einem Verdampfertiegel, der an dem Verdampfer gehalten ist.

**6.** Verdampfervorrichtung nach einem der voranstehenden Ansprüche, wobei der Abschirmrahmen und der Rahmen die gleiche dreidimensionale Form aufweisen und der Abschirmrahmen ein kleineres Volumen als der Rahmen aufweist.

**7.** Verdampfervorrichtung nach einem der voranstehenden Ansprüche, wobei der Abschirmrahmen und der Rahmen Hohlzylinder sind.

**8.** Verdampfervorrichtung nach einem der voranstehenden Ansprüche, wobei der Abschirmrahmen und der Rahmen jeweils rohrförmig sind und/oder die Öffnungen des Rahmens und des Abschirmrahmens Rohröffnungen sind.

**9.** Verdampfervorrichtung nach einem der voranstehenden Ansprüche, wobei der Abschirmrahmen und der Rahmen Materialien und Dimensionen aufweisen, die ausgelegt sind zum Bereitstellen, wenn der Abschirmrahmen innerhalb des Rahmens angebracht ist, eines Freiraums zwischen dem Abschirmrahmen und dem Rahmen bei einer Nicht-Betriebstemperatur der Verdampfertemperatur, und einer engen Passung zwischen dem Abschirmrahmen und dem Rahmen bei einer Betriebstemperatur der Verdampfervorrichtung.

**10.** Verdampfervorrichtung nach einem der voranstehenden Ansprüche,
wobei das Material von zumindest dem Abschirmrahmen und/oder dem Rahmen einen linearen thermischen Ausdehnungskoeffizienten in dem Bereich von 5 x $10^{-6}$/K bis 45 x $10^{-6}$/K bei 20°C oder in dem Bereich von 10 x $10^{-6}$/K bis 20 x $10^{-6}$/K bei 20°C aufweist, und/oder
wobei das Material von zumindest dem Abschirmrahmen und/oder dem Rahmen einen thermischen Volumen-Ausdehnungskoeffizienten in dem Bereich von 10 x $10^{-6}$/K bis 90 x $10^{-6}$/K bei 20°C oder in dem Bereich von 30 x $10^{-6}$/K bis 60 x $10^{-6}$/K bei 20°C aufweist.

**11.** Verdampfervorrichtung nach einem der voranstehenden Ansprüche, wobei das Material von zumindest dem Abschirmrahmen und/oder dem Rahmen ein Metall einschließt, und/oder wobei das Material von zumindest dem Abschirmrahmen und/oder dem Rahmen zumindest ein Element einschließt, das gewählt ist aus der Gruppe, die besteht aus einem hochschmelzenden Metall, Eisen und Edelstahl.

**12.** Verfahren zum Zusammenbauen einer Verdampfervorrichtung, umfassend

Bereitstellen einer Verdampfervorrichtung nach einem der Ansprüche 1 bis 11,
Anordnen des Abschirmrahmens im Wesentlichen konzentrisch innerhalb von dem und angrenzend an den Rahmen, und
wahlweises Anbringen eines Verdampfertiegels an dem Verdampfer.

13. Verwendung einer Verdampfervorrichtung nach einem der Ansprüche 1 bis 11 in einem Verfahren zum Betreiben einer Verdampfervorrichtung, umfassend Bereitstellen der Verdampfervorrichtung, die den Abschirmrahmen im Wesentlichen konzentrisch innerhalb von dem und angrenzend an den Rahmen angebracht aufweist und einen Verdampfertiegel aufweist, der an dem Verdampfer bereitgestellt ist, Kühlen des Rahmens, und
Erwärmen des Verdampfertiegels.

14. Verwendung nach Anspruch 13, wobei die Verdampfervorrichtung in einem Verfahren zum Beschichten von einem oder mehreren Substraten verwendet wird.

15. Beschichtungsvorrichtung, umfassend eine Verdampfervorrichtung nach einem der Ansprüche 1 bis 11.

**Revendications**

1. Dispositif évaporateur comprenant :

   un châssis (10) ayant une ouverture et pouvant être relié à une unité de refroidissement pour refroidir le châssis,
   un évaporateur (30) étant adapté pour supporter un creuset d'évaporateur à l'intérieur du châssis, et
   un châssis de protection (20),
   dans lequel le châssis de protection est sensiblement concentrique à l'intérieur et à proximité du châssis et peut être installé de manière démontable à travers l'ouverture de châssis, et
   dans lequel le châssis de protection a une structure adaptée pour assurer, lorsqu'il est installé à l'intérieur du châssis, un jeu par rapport au châssis à une température hors fonctionnement du dispositif évaporateur et un ajustement sans jeu avec le châssis à une température de fonctionnement du dispositif évaporateur.

2. Dispositif évaporateur selon la revendication 1, dans lequel le châssis de protection a une structure adaptée pour assurer un jeu par rapport au châssis à une température hors fonctionnement du creuset d'évaporateur et un ajustement sans jeu avec le châssis à une température de fonctionnement du creuset d'évaporateur.

3. Dispositif évaporateur selon l'une quelconque des revendications précédentes, dans lequel
le dispositif évaporateur a un côté évaporation, l'ouverture du châssis est agencée du côté évaporation du dispositif évaporateur, et/ou
le châssis de protection a une ouverture et peut être installé à l'intérieur du châssis de telle sorte que l'ouverture du châssis de protection est agencée du côté évaporation du dispositif évaporateur.

4. Dispositif évaporateur selon l'une quelconque des revendications précédentes, dans lequel l'évaporateur est agencé sur une paroi intérieure du châssis, et/ou le châssis de protection a au moins un évidement pour recevoir l'évaporateur.

5. Dispositif évaporateur selon l'une quelconque des revendications précédentes, dans lequel l'évaporateur comprend un connecteur électrique adapté pour fournir du courant de chauffage à un creuset d'évaporateur supporté sur l'évaporateur.

6. Dispositif évaporateur selon l'une quelconque des revendications précédentes, dans lequel le châssis de protection et le châssis ont la même forme tridimensionnelle et le châssis de protection a un volume inférieur au châssis.

7. Dispositif évaporateur selon l'une quelconque des revendications précédentes, dans lequel le châssis de protection et le châssis sont des cylindres creux.

8. Dispositif évaporateur selon l'une quelconque des revendications précédentes, dans lequel le châssis de protection et le châssis sont chacun tubulaires et/ou les ouvertures du châssis et du châssis de protection sont des ouvertures de tube.

9. Dispositif évaporateur selon l'une quelconque des revendications précédentes, dans lequel le châssis de protection et le châssis ont des matériaux et dimensions adaptés pour assurer, lorsque le châssis de protection est installé à l'intérieur du châssis, un jeu entre le châssis de protection et le châssis à une température hors fonctionnement du dispositif évaporateur, et
un ajustement sans jeu entre le châssis de protection et le châssis à une température de fonctionnement du dispositif évaporateur.

10. Dispositif évaporateur selon l'une quelconque des revendications précédentes,
dans lequel le matériau d'au moins l'un du châssis de protection et du châssis a un coefficient de dilatation thermique linéaire dans l'intervalle de 5 x $10^{-6}$/K à 45 x $10^{-6}$/K à 20 °C, ou dans l'intervalle de

10 x 10$^{-6}$/K à 20 x 10$^{-6}$/K à 20 °C, et/ou dans lequel le matériau d'au moins l'un du châssis de protection et du châssis a un coefficient de dilatation thermique volumique dans l'intervalle de 10 x 10$^{-6}$/K à 90 x 10$^{-6}$/K à 20 °C, ou dans l'intervalle de 30 x 10$^{-6}$/K à 60 x 10$^{-6}$/K à 20 °C.

**11.** Dispositif évaporateur selon l'une quelconque des revendications précédentes, dans lequel le matériau d'au moins l'un du châssis de protection et du châssis comprend un métal, et/ou dans lequel le matériau d'au moins l'un du châssis de protection et du châssis comprend au moins un élément choisi parmi le groupe constitué d'un métal réfractaire, de fer et d'acier inoxydable.

**12.** Procédé de montage d'un dispositif évaporateur, comprenant
la fourniture d'un dispositif évaporateur selon l'une quelconque des revendications 1 à 11,
l'agencement du châssis de protection de manière sensiblement concentrique à l'intérieur et à proximité du châssis, et
l'installation facultative d'un creuset d'évaporateur sur l'évaporateur.

**13.** Utilisation d'un dispositif évaporateur selon l'une quelconque des revendications 1 à 11 dans un procédé de fonctionnement d'un dispositif évaporateur, comprenant
la fourniture du dispositif évaporateur ayant le châssis de protection installé de manière sensiblement concentrique à l'intérieur et à proximité du châssis, et ayant un creuset d'évaporateur agencé sur l'évaporateur,
le refroidissement du châssis, et
le chauffage du creuset d'évaporateur.

**14.** Utilisation selon la revendication 13, dans laquelle le dispositif évaporateur est utilisé dans un procédé de revêtement d'un ou de plusieurs substrats.

**15.** Dispositif de revêtement, comprenant un dispositif évaporateur selon l'une quelconque des revendications 1 à 11.

FIG 1a

FIG 1b

## FIG 1c

## FIG 2a

## FIG 2b

20

23

320

22

## FIG 2c

20

23

25

320

22

FIG 3

FIG 4

## FIG 5

## FIG 6

**EP 2 180 080 B1**

**REFERENCES CITED IN THE DESCRIPTION**

**Patent documents cited in the description**

- JP 9228032 A

- EP 0336618 A